# EUROPEAN PATENT SPECIFICATION

(11) **EP 2 738 607 B1**
(45) Date of publication and mention of the grant of the patent: **18.05.2016**
(21) Application number: 12818389.4
(22) Date of filing: 17.07.2012
(51) Int. Cl.: G03F 7/20, G01R 31/00, G01R 31/315, H01L 21/66, H01J 37/317, H01J 37/26

(54) **NANOPATTERNING AND ULTRA-WIDEBAND ELECTROMAGNETIC CHARACTERISTIC MEASUREMENT SYSTEM**
SYSTEM ZUR MESSUNG VON NANOSTRUKTURIERUNGEN UND VON ULTRABREITBANDIGEN ELEKTROMAGNETISCHEN CHARAKTERISTIKEN
SYSTÈME DE MESURE DE STRUCTURES NANOGRAPHIQUES ET DE CARACTÉRISTIQUES ÉLECTROMAGNÉTIQUES À BANDE ULTRA LARGE

(30) Priority: 26.07.2011 CN 201110209908
(43) Date of publication of application: 04.06.2014
(73) Proprietor: Institute Of Physics Chinese Academy Of Sciences, Beijing 100190 (CN); Germantech Co., Ltd., Beijing 100083 (CN)
(72) Inventor: HAN, Xiufeng, Beijing 100190 (CN); MA, Qinli, Beijing 100190 (CN); YU, Guoqiang, Beijing 100190 (CN); LIU, Houfang, Beijing 100190 (CN); YU, Tian, Beijing 100190 (CN); ZHOU, Xiangqian, Beijing 100083 (CN); AI, Jinhu, Beijing 100083 (CN); SUN, Xiaoyu, Beijing 100083 (CN)
(74) Representative: Nederlandsch Octrooibureau
(86) International application number: PCT/CN2012/078747
(87) International publication number: WO 2013/013584

(56) References cited:
- EP-A1- 1 798 751
- EP-A2- 1 319 733
- CN-A- 101 441 410
- CN-A- 101 625 303
- CN-U- 202 189 227
- CN-Y- 2 751 297
- JP-A- 2001 141 776
- US-A- 5 900 645
- US-A1- 2004 061 051
- US-A1- 2006 164 115
- US-A1- 2010 079 908
- US-B1- 6 426 499

## Description

### TECHNICAL FIELD

The present invention relates to apparatus for detection of nanomaterials and devices, and particularly to a nano-patterning and ultra-wideband electromagnetic characteristic measurement system for the generation, introduction, transmission and measurement of high frequency electromagnetic signals and for a large-scale nanometer positioning, based on a magnetic field applied by an electron beam lithography system/electron beam pattern generation system.

### BACKGROUND ART

With the development of nano-processing and testing technology, nanomaterials and devices have been widely used in many fields, including for example the fields of electronics, magnetics, chemistry and biology, etc. The study of nanomaterials and devices has become one of the core issues of condensed matter physics and modern information technology and the industrial production. Since 1988, the rapid development of spintronics has gradually led information science to an era of very high density magnetic storage (T-bit/inch²) containing nano-magnetic materials and nanosecond fast reading and writing. This means the study of nanomaterials and devices is going to enter a complete process of comprehensive measurement and analysis, comprising nanometer microstructure imaging, nano-patterning and GHz high frequency operations and involving magnetic or electric fields.
At present, Electron Beam Lithography (EBL) System is one of the important equipment for integration of the preparation and observation of nanostructures. It comprises a scanning electron microscopy (SEM) imaging function and an electron beam pattern generator, i.e. it writes nano-patterns directly on a resist layer using a focused electron beam. As the electron beam is characterized by a small beam spot and high energy, nanostructures with a line width of 5 to 10 nm can be produced using an EBL system. This is the ideal method for making nanomaterials and devices. Currently, the world record of the production of nanostructures with a minimum line width of less than 5 nm was set by Raith GmbH (Germany) and has been held by it so far. Although some EBL systems have been integrated with probe arms having a function of measuring electrical signals, yet the existing EBL systems are unable to make the direct observation of nano materials and devices compatible with the manipulation and measurement of *in-situ* electrical/magnetic signals. This bottleneck problem is caused mainly because that the electrons used for exposure and imaging in an EBL system will deflect under the action of an external magnetic or electric field applied for the *in-situ* measurement of a sample, which will seriously interfere with and influence the focusing and scanning of an electron beam. Further, since probe structures have not been specially designed, they cannot transmit or measure high frequency signals in an electron beam vacuum system, and thus cannot transmit or measure high frequency signals in an *in-situ* nanodevice. At the present stage, either at home or abroad, the usual method of testing the high-frequency magnetic/electrical transport characteristics of nanomaterials and devices comprises the steps of: first fabricating a special electrode structure for high frequency signal transmission by means of EBL exposure in combination with multi-step micro/nano processing, performing a preliminary DC or low-frequency AC magneto-electric characteristic test, and then placing it in a special high-frequency test system for measuring magneto-electric high-frequency response signals. Nano-scale patterning technology is difficult and time-consuming and involves cumbersome processing and measurement processes, etc., thus not only increasing the manufacture cost but also greatly extending the test time of nanomaterials and devices, whereupon the success rate and yield are significantly affected. In addition, although the existing EBL systems have been integrated with probe arms having nanoscale positioning capabilities, they are unable to perform a precise nanometer positioning within 1 inch or more, but can only locate and connect a probe and a sample within a narrow range(within just a few microns).

It is observed that CN101299024discloses a Nano-Patterning and Photoresponse Characteristic Measurement System.

### DISCLOSURE OF THE INVENTION

The technical problem to be solved by the present invention is to provide a nano-patterning and ultra-wideband electromagnetic characteristic measurement system for the patterning and morphology observation of array nanomaterials and devices and for the testing and analysis of ultra-wideband magnetic/electrical transport characteristics under *in-situ* conditions.

To this end, the present invention provides a nano-patterning and ultra-wideband electromagnetic characteristic measurement system, comprising a power source, a control device and a measurement device, the control device being connected to the measurement device, and the control device and the measurement device being respectively connected to the power source, wherein the measurement device includes an imaging device with an SEM imaging or EBL patterning function, a vacuum chamber, a vacuum system, a sample stage and a magnetic-field response characteristic test device, wherein the vacuum system is connected to the vacuum chamber, wherein the imaging device, the sample stage and the magnetic-field response characteristic test device all are arranged inside the vacuum chamber, and wherein the imaging device and the magnetic-field response characteristic test device are arranged relative to the sample stage.

In the nano-patterning and ultra-wideband electromagnetic characteristic measurement system, the magnetic-field response characteristic test device comprises a bracket, and a magnetic-field generation device and a magnetic-field moving apparatus 353 that are mounted on the bracket, wherein the magnetic-field generation device includes a coil and magnetically permeable magnetic poles, and the magnetically permeable magnetic poles are connected to the magnetic-field moving apparatus 353.

In the nano-patterning and ultra-wideband electromagnetic characteristic measurement system, the magnetically permeable magnetic poles are cone-shaped structural parts made of a soft magnetic material, which is an NiFe alloy, a silicon steel disc, or soft magnetic ferrite.

In the nano-patterning and ultra-wideband electromagnetic characteristic measurement system, the coil is a Helmholtz coil.

In the nano-patterning and ultra-wideband electromagnetic characteristic measurement system, the magnetic-field response characteristic test device further comprises a magnetic-field shielding mechanism, which is mounted on the bracket arranged relative to the sample stage.

In the nano-patterning and ultra-wideband electromagnetic characteristic measurement system, the magnetic-field shielding mechanism is a magnetic field shield cap or plate.

The nano-patterning and ultra-wideband electromagnetic characteristic measurement system further comprises an electric-field response characteristic test device, which is arranged inside the vacuum chamber and disposed above the sample stage.

In the nano-patterning and ultra-wideband electromagnetic characteristic measurement system, the electric-field response characteristic test device includes a plate applying vertical electric-field and/or plates applying horizontal electric-field and a plate moving apparatus , the plate applying vertical electric-field and/or the plates applying horizontal electric-field being respectively connected to the plate moving apparatus.

The nano-patterning and ultra-wideband electromagnetic characteristic measurement system further comprises a photo response characteristic test device which includes a light source and a photo response characteristic testing component, wherein the photo response characteristic testing component is arranged inside the vacuum chamber.

In the nano-patterning and ultra-wideband electromagnetic characteristic measurement system, the photo response characteristic testing component includes an optical fiber, a fiber optic probe and a movable bracket, wherein the optical fiber is connected between the light source and the fiber optic probe, the fiber optic probe is mounted on the movable bracket, and the movable bracket is arranged, relative to the sample stage, inside the vacuum chamber.

The nano-patterning and ultra-wideband electromagnetic characteristic measurement system further comprises a wideband signal test analysis device which includes a signal generation device, a signal transmission device and a signal analysis device, wherein the signal generation device and the signal analysis device are respectively connected to the signal transmission device, and the signal transmission device is connected to the vacuum chamber and arranged relative to the sample stage.

In the nano-patterning and ultra-wideband electromagnetic characteristic measurement system, the signal transmission device comprises high frequency probe arms and/or low frequency probe arms, probe arm moving apparatus and probes, the high frequency probe arms and/or the low frequency probe arms being connected to the probe arm moving apparatus, and the probes being mounted at the front ends of the high frequency probe arms and/or the low frequency probe arms.

In the nano-patterning and ultra-wideband electromagnetic characteristic measurement system, the probe arm moving apparatus includes a three-dimensional mechanically moving part and a three-dimensional piezoelectrically moving part.

In the nano-patterning and ultra-wideband electromagnetic characteristic measurement system, the high frequency probe arm includes a first probe arm and a second probe arm, wherein the three-dimensional mechanically moving part is connected to the first probe arm via a corrugated tube, and the first and second probe arms are connected via the three-dimensional piezoelectrically moving part.

In the nano-patterning and ultra-wideband electromagnetic characteristic measurement system, the signal transmission device further comprises probe positioning apparatus, which are mounted at the front ends of the high frequency probe arms and/or the low frequency probe arms and are connected to the control device.

In the nano-patterning and ultra-wideband electromagnetic characteristic measurement system, the signal generation device comprises a high frequency network analyzer, a voltage source and a current source, the high frequency probe arms and/or the low frequency probe arms being connected to the high frequency network analyzer, the voltage source and the current source, respectively.

In the nano-patterning and ultra-wideband electromagnetic characteristic measurement system, a sample stage moving apparatus is further arranged inside the vacuum chamber, the sample stage being mounted on the sample stage moving mechanism which is connected to the control device.

Hereinafter, the unity model is described in detail with reference to the accompanying drawings and embodiments, which, however, are not used to limit the unity model.

### BRIEF DESCRIPTION OF THE DRAWINGS

FIG. 1 is a block diagram of the structure of the present invention;
FIG. 2 is a block diagram illustrating the structure of a measurement device in an embodiment of the present invention;
FIG. 3 is a working schematic diagram of an imaging device according to the present invention;
FIG.4 illustrates the structure of an embodiment of the present invention;
FIG. 5A illustrates the internal structure of a vacuum chamber in an embodiment of the present invention;
FIG. 5B illustrates the structure of a magnetic-field response characteristic test device in an embodiment of the present invention (both the magnetic-field generation device and the magnetic-field shielding mechanism are in an Off state);
FIG. 5C illustrates the structure of a magnetic-field response characteristic test device in an embodiment of the present invention (both the magnetic-field generation device and the magnetic-field shielding mechanism are in an ON state);
FIG. 6A illustrates the structure of a vertical electric-field response characteristic test device in an embodiment of the present invention;
FIG. 6B illustrates the structure of a horizontal electric-field response characteristic test device in an embodiment of the present invention;
FIG. 7 illustrates the structure of a photo response characteristic test device in an embodiment of the present invention;
FIG. 8 illustrates the structure of a high frequency probe arm in an embodiment of the present invention; and
FIG. 9 illustrates the structure of a high frequency probe arm when using a conductive sensor in an embodiment of the present invention.

The following are the relevant drawing reference signs:
- 1: Power source
- 2: Control device
21 Control Panel
22 Control Host
23 Communication Interface
- 3: Measurement device
31 Imaging device
311 Electron gun
312 Secondary electron detector
32 Vacuum chamber
33 Vacuum system
34 Sample stage
341 Sample stage moving mechanism
342 Vertical-lift small-sized sample stage
35 Magnetic-field response characteristic test device
351 Bracket
352 Magnetic-field generation device
3521 Coil
3522 Magnetically permeable magnetic pole
353 Magnetic-field moving apparatus
354 Magnetic-field shielding apparatus
36 Electric-field response characteristic test device
361 Plate applying vertical electric-field
362 Plate applying horizontal electric-field
37 Photo response characteristic test device
371 Light source
372 Photo response characteristic test component
3721 Optical fiber
3722 Fiber optic probe
3723 Movable bracket
3724 Interface
38 Wideband signal test analysis device
381 Signal generation device
3811 High frequency network analyzer
3812 Voltage source
3813 Current source
382 Signal transmission device
3821 High frequency probe arm
38211 First probe arm
38212 Second probe arm
3822 Low frequency probe arm
3823 Probe arm moving mechanism
38231 Three-dimensional mechanically moving part
38232 Three-dimensional piezoelectrically moving part
38233 Corrugated tube
3824 Probe
3825 Probe positioning apparatus
383 Signal analysis device
4 Sample

### BEST MODE FOR CARRYING OUT THE INVENTION

The structural principle and working principle of the present invention are specifically described hereinafter with reference to the accompanying drawings:

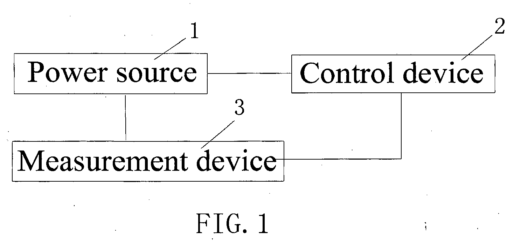

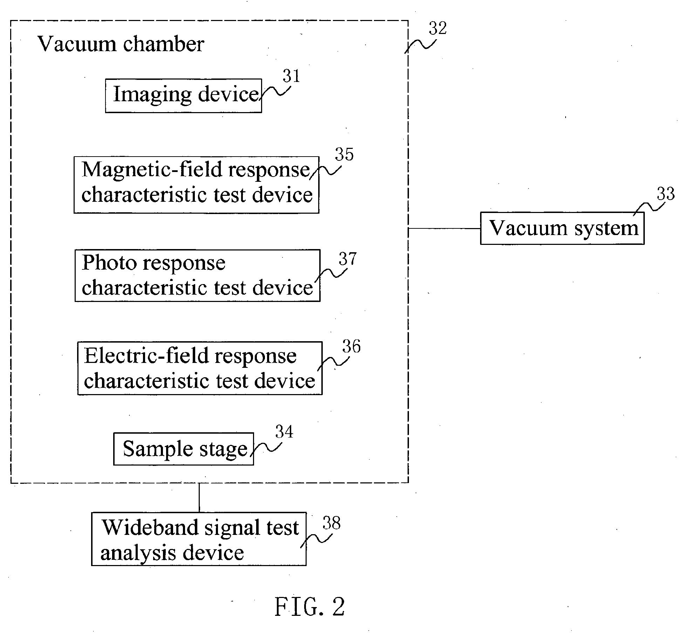

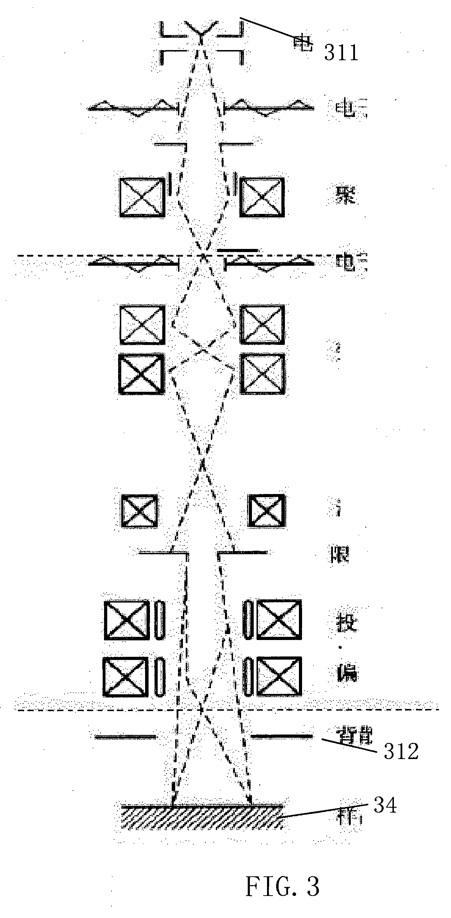

In the present invention, a magnetic field for measurement is led onto a sample stage with an SEM imaging or EBL patterning function, so as to perform a magnetic-field response characteristic test on a nanomaterial or device to be tested. Referring to FIGS. 1, 2 and 3, among which FIG. 1 is a block diagram of the structure of the present invention, FIG. 2 is a block diagram illustrating the structure of a measurement device in an embodiment of the present invention, and FIG. 3 is a working schematic diagram of an imaging device according to the present invention, the nano-patterning and ultra-wideband electromagnetic characteristic measurement system according to the present invention comprises a power source 1, a control device 2 and a measurement device 3, the control device 2being connected to the measurement device 3, and the control device 2 and the measurement device 3 being respectively connected to the power source 1, wherein the measurement device 3 includes an imaging device 31 with an SEM imaging or EBL patterning function, a vacuum chamber 32, a vacuum system 33, a sample stage 34 and a magnetic-field response characteristic test device 35, wherein the vacuum system 33 is connected to the vacuum chamber 32, wherein the imaging device 31, the sample stage 34 and the magnetic-field response characteristic test device 35 all are arranged inside the vacuum chamber 32, and wherein the imaging device 31 and the magnetic-field response characteristic test device 35 are arranged relative to the sample stage 34. The imaging device 31 according to the present invention comprises an electron gun 311 and a secondary electron detector 312. The principle of the SEM imaging or EBL patterning function of the imaging device 31 is shown in FIG. 3. Since the structure and principle of said imaging device belong to existing mature technologies, the details are not repeated here. The imaging device 31 with an SEM imaging or EBL patterning function, the vacuum chamber 32, the vacuum system 33 and the sample stage 34 can also be manufactured directly using experimental or industrial grade EBL equipment, which is already a mature technology at present. The EBL equipment comprises three basic parts: an electron gun, an electron lens, an electron deflector, and other auxiliary components (beam current measuring means, adapted for measuring the size of an electron beam current for exposure; reflected electron measuring means, adapted for observing the alignment mark on the surface of a sample; a working platform, adapted for accommodating and moving an exposed sample; a vacuum system; a high voltage power supply; and a computer pattern generator, adapted for converting graphic data to electrical signals that control the deflector).According to the shapes of electron beams, electron beam lithography systems can be divided into two types: Gaussian beam (or circular beam) and variable shaped beam (or rectangular beam). Gaussian beam is named for the reason that the current distribution in the circular beam spot is a Gaussian function. Gaussian beam electron beam lithography system is a vector-scan exposure system, which has a higher resolution but a much lower scanning speed than the speed of raster scanning. A representative system is Raith 150 Electron Beam Lithography System from Raith GmbH (Germany), which has both a scanning electron microscopy function and an electron beam lithography function, with a minimum beam diameter of 4 nm. It is mainly characterized by comprising: an energy-adjustable electron gun with an electron energy of from 5 keV to 300keV; a secondary electron detector having a magnetic lens group with an electron beam focusing function and having an SEM imaging function; an electron beam control electrode having an electron beam focusing and deflection function for direct writing of an electron beam, and the corresponding software; a sample stage that can move freely in a horizontal two-dimensional direction within 1 inch or more, with a positioning accuracy of 10 nm and a size of 1 to 12 inches; a chamber, where the electron beam and the sample are located, having a background vacuum pressure exceeding 10 to 5 Pa. All the devices of the present invention are connected via GPIB cable 23, controlled by the control software in the control host 22 of the control device2, and manipulated via the control panel 21.Since their structures and functions all are existing mature technologies, the details are not repeated here.

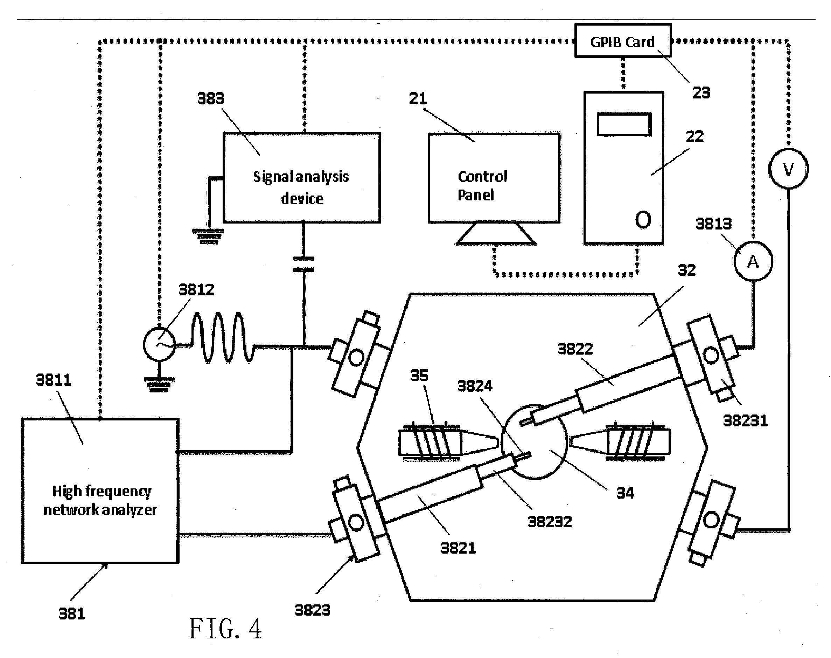

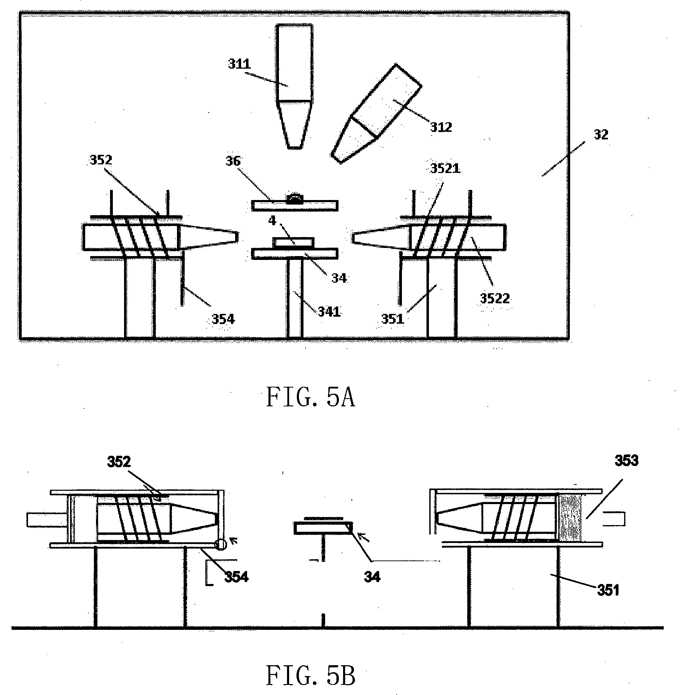

Referring to FIGS. 4 and 5A, of which FIG. 4 illustrates the structure of an embodiment of the present invention, and FIG. 5A illustrates the internal structure of a vacuum chamber in an embodiment of the present invention, in this embodiment, the magnetic-field response characteristic testing device 35 comprises a bracket 351, and a magnetic-field generation device 352 and a magnetic-field moving apparatus 353 that are mounted on the bracket 351, wherein the magnetic-field generation device 352 includes a coil 3521 and magnetically permeable magnetic poles 3522, and the magnetically permeable magnetic poles 3522 are connected to the magnetic-field moving mechanism 353. Preferably, the magnetically permeable magnetic poles 3522 are cone-shaped structural parts made of a soft magnetic material. That's because they are easy to magnetize and demagnetize, then a very high magnetic permeability enables them to have an enhanced magnetic field strength and a reduced remanence. Preferably, the soft magnetic material is an NiFe alloy, a silicon steel disc, or soft magnetic ferrite. Preferably, the coil 3521 is a pair of Helmholtz coils 3521. In this embodiment, the magnetic field is generated by a pair of Helmholtz coils3521 inside the vacuum chamber, and is efficiently transmitted to the vicinity of the sample stage 34 via the cone-shaped, magnetically permeable magnetic poles 3522 made of a soft magnetic material. The direction and size of the magnetic field are controlled by a DC power capable of changing the direction and continuously varying the magnitude, and their ranges can be set according to the need. The maximum amplitude of the magnetic field is controlled to from 500 0e to 5000 0e. The overall Helmholtz coils and soft magnetically permeable magnetic poles are covered by a magnetic-field shield cap made of a high permeability ferromagnetic material. In addition, when the magnetic-field current source is turned off and the magnetically permeable magnetic poles do not work, a magnet shield baffle provided at the front end of the magnet shield cap is in an Off state to achieve the best magnetic field shielding effect, thus effectively avoiding the influence of the remanence of the magnetically permeable magnetic poles and the influence of the stray magnetic fields on the electron beam, as shown in FIG. 5B. When an external magnetic field is employed for measurement, the magnet shield baffle opens and the soft magnetically permeable magnetic poles can move out and approach the sample stage 34. A stepper motor device is employed to manipulate the movement of the magnetically permeable magnetic poles, so that they can be adjusted continuously and precisely.

The Helmholtz coils are wound conductive wires with high electrical conductivity. The conductive wire diameter is 0.2 to 2 mm, and the number of turns and the diameter of said coil can be determined according to the desired magnetic field. Periphery of said coil can be cooled by wrapping it with a circulating water jacket. Said magnetic pole is of a conical structure, and the tip of the electrode is designed into a concave surface such that the end close to the sample stage can increase the density of magnetic lines of force and generate a uniform magnetic field. Said soft magnetic material is a material characterized by high permeability and small remanence. Pure iron and low carbon steel, Fe-Si alloys, Fe-Al alloys, Fe-Si-Al alloys, Ni-Fe alloys, Fe-Co alloys, soft magnetic ferrite, amorphous soft magnetic alloys, and ultra-crystalline soft magnetic alloys with a particle size of about 50nm are preferred. The soft magnetic core magnetic electrode is manipulated by a mechanical transmission device controlled by a stepper motor, and can freely extend and exit within 10 to 50 cm. Its movement is controlled by the corresponding software and program.

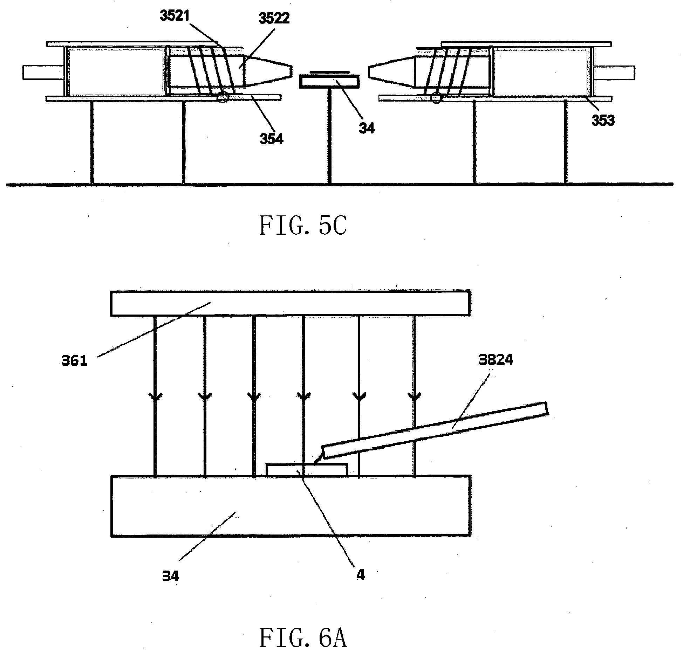

In this embodiment, the magnetically permeable magnetic poles 3522 can be controlled by a mechanical device (e.g., a stepper motor or a hydraulic pump) to move close to or away from the sample. When there is a need for an external magnetic field, their magnetic heads can move and approach the sample stage 34 and, meanwhile, the current source of the Helmholtz coils supplies a current to the magnetic field; when there is no need for an external magnetic field or an electron beam is used for direct writing or imaging, the magnetically permeable magnetic poles 3522 retreat away from the sample stage 34 while the current source for applying a magnetic field is turned off and, meanwhile, electromagnetic shielding measures can also be taken to ensure that the manipulation of an electron beam for direct writing or imaging is not affected. The magnetic-field response characteristic test device 35 further comprises a magnetic-field shielding apparatus 354, which is mounted on the bracket 351 and arranged relative to the sample stage 34 (see FIG. 5B and FIG. 5C). In this embodiment, the magnetic-field shielding apparatus 354 is preferably a magnetic shielding cap or plate.

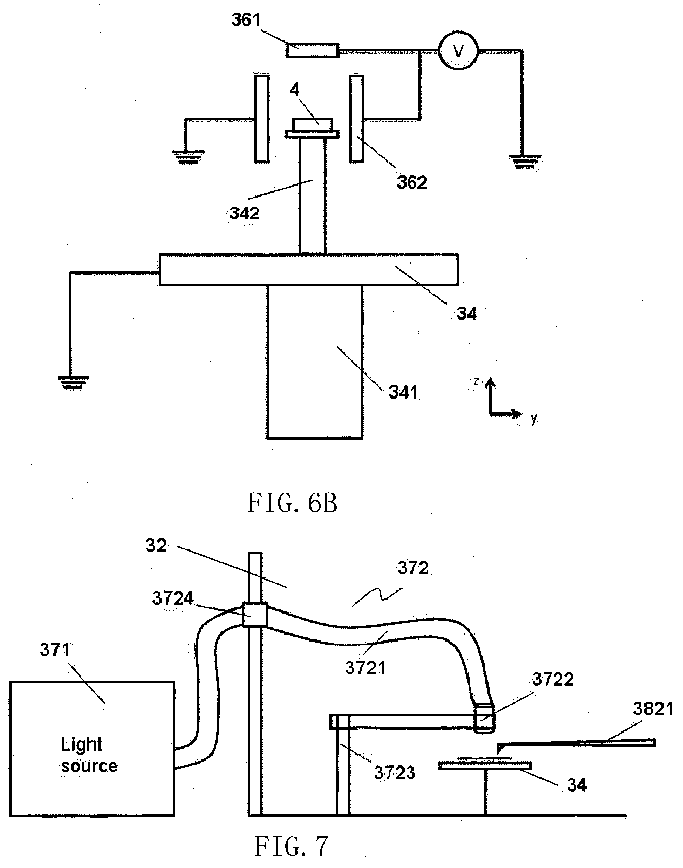

Referring to FIG. 6A and FIG. 6B, of which FIG. 6A illustrates the structure of a vertical electric-field response characteristic test device in an embodiment of the present invention and FIG.6B illustrates the structure of a horizontal electric-field response characteristic test device in an embodiment of the present invention, the measurement system 3 according to the present invention further comprises an electric-field response characteristic test device 36, which is arranged inside the vacuum chamber 32 and disposed above the sample stage 34. In this embodiment, the electric-field response characteristic test device 36 includes a vertical electric-field applying plate 361 and/or horizontal electric-field applying plates 362 and a plate moving apparatus (not shown), wherein the vertical electric-field applying plate 361 and/or the horizontal electric-field applying plates 362 are respectively connected to the plate moving mechanism. The horizontal electric-field applying plates 362 and/or the vertical electric-field applying plate 361,respectively, leads an electric field applied in a horizontal or vertical direction onto the sample stage 34,so as to test the electric-field response characteristics of nano-materials and devices. The horizontal electric-field applying plates 362 and/or the vertical electric-field applying plate 361respectively can be a pair of relatively movable metal plate electrodes disposed inside the vacuum chamber 32. Or, a voltage is applied to a movable metal plate electrode of the same shape and the same size, which is disposed over the metal, conductive sample stage 34, to generate a horizontal or vertical electric field, and the applied voltage may be between 0 to 110 or 220V, or a higher voltage (generating a stronger electric field) is applied according to the needs of the test. The voltage may be a DC voltage, or an AC voltage (the electric field thus generated can be a steady electric field or an alternating electric field). In the case where there is no need for an external electric field, move and draw back the pair of horizontal electric-field applying plates 362 or elevate the vertical electric-field applying plate 361 over the sample stage 34, such that it retreats to the edge of the wall of the vacuum chamber 32 and is away from the sample stage 34 and the central region where the electron beam is working inside the vacuum chamber. In order to reduce the influence of the metal sample stage on the distribution of an in-plane electric field, a vertical-lift small-sized sample stage 342 which rises from the middle of the sample stage 34 is used to lift the sample 4 up and place it between two metal electrodes, and then an in-plane electric field is applied using the two metal plate electrodes, as shown in FIG. 6B.

The size of the electric field applied to a nano-material or device can be adjusted by adjusting the distance between the pair of horizontal electric-field applying plates 362 or adjusting the distance between the vertical electric-field applying plate 361, of which the top is movable, and the sample stage 34, and also can be further adjusted at a constant voltage. Of course, the size of the electric field can also be adjusted by changing the applied voltage, after the distance between the two metal plate electrodes has been selected.

The vertical electric field is generated by applying a voltage between the metal sample stage 34 and the vertical electric-field applying plate 361, which is a movable metal plate electrode of the same shape and the same size and disposed right over it. The distance between the two is adjustable (<10 cm).In the case where there is no need for a vertical electric field, the vertical electric-field applying plate 361 overthe sample stage 34 can be elevated vertically and then be horizontally moved out of the measurement range of the sample stage 34. The size of the vertical electric-field applying plate 361 can be adjusted according to actual needs. The vertical electric-field applying plate 361 is generally of the same shape and the same size (between 1-12 inches) as the test sample stage 34. In this way, the most uniform vertical electric field can be formed.

Two methods can be used to apply a voltage to said vertical electric-field applying plate 361. One method is to apply a voltage (electric field) when an *in situ* test is performed using a probe. The other one is that, in order to reduce the influence of a probe itself on the electric-field distribution, first an electric field can be applied to the sample, remove the movable metal plate electrodes, and then perform an electromagnetic characteristic test on the nano-material or device. However, the latter method only applies to nano-materials or devices having a memory effect on the electromagnetic field response. Referring to FIG. 7, which illustrates the structure of a photo response characteristic test device in an embodiment of the present invention, the measurement system 3 according to the present invention further comprises a photo response characteristic test device 37, which is arranged inside the vacuum chamber 32. In this embodiment, the photo response characteristic test device 37 includes a light source 371 and a photo response characteristic test component 372, the photo response characteristic test component 372 is arranged inside the vacuum chamber 32, and a light beam (or alight wave/light field in the frequency band of laser, infrared, ultraviolet or the like) can be introduced into the vacuum chamber 32 and irradiated on the sample 4, so as to test the photo response characteristics of the nano-material or device to be tested. The photo response characteristic test component 372 includes an optical fiber 3721, a fiber optic probe 3722 and a movable bracket 3723, one end of the optical fiber 3721 is connected to the light source 371,the optical fiber 3721 enters the vacuum chamber 32 by penetrating through the wall of the vacuum chamber 32 via the interface 3724, the other end of the optical fiber 3721 is connected to the fiber optic probe 3722,the optical fiber 3721 led into the vacuum chamber 32 is used to transmit a light beam, the fiber optic probe 3722 is mounted on the movable bracket 3723, and the movable bracket 3723is arranged, relative to the sample stage 34, inside the vacuum chamber 32.Laser or a light beam generated by another light source is led into the vacuum chamber 32 via the optical fiber 3721 and led onto the surface of the sample 4. Regarding the wavelength, intensity, monochromaticity and other properties of the introduced light, different light sources or lasers can be configured according to the different needs for optical radiation or excitation of the sample 4 to be tested. In the case where there is no need to study the optical radiation or excitation, the optical fiber 3721 and the fiber optic probe 3722 can be moved by the movable bracket 3723 to the vicinity of the wall of the vacuum chamber 32, thus being away from the central region for electron beam (EBL)direct writing and SEM imaging.

Referring to FIG. 4, the measurement system 3 according to the present invention further comprises a wideband signal test analysis device 38, which leads wideband signals(in the range of 0 to 10, 20, 40, 60 or 100 GHz) into the vacuum chamber 32, and functions to transmit, import and export, test and analyze signals, etc. To meet the need for different signals, the input of signals in different frequency bands, e.g. RF signals of below300 MHz or high frequency signals of above 300 MHz and up to 100 GHz, can be configured. The import and export of high frequency signals can be achieved by the specially designed, movable high frequency probe arms3821, and said signals can be applied to a nanostructure or device using high frequency probes 3824, thereby accomplishing the application and detection of high frequency signals. The import and export of low frequency signals can be achieved by the movable low frequency probe arms3822, and said signals can be applied to a nanostructure or device using the probes 3824, thereby accomplishing the application and detection of low frequency and DC signals. The wideband signal test analysis device 38 includes a signal generation device 381, a signal transmission device 382 and a signal analysis device 383, wherein the signal generation device 381 and the signal analysis device 383 are respectively connected to the signal transmission device 382, and the signal transmission device 382 is connected to the vacuum chamber 32 and arranged relative to the sample stage 34. In this embodiment, the signal transmission device 382 comprises high frequency probe arms 3821 and/or low frequency probe arms 3822, probe arm moving mechanisms 3823 and probes 3824, wherein the high frequency probe arms 3821and/or the low frequency probe arms 3822 are connected to the probe arm moving mechanisms 3823, and the probes 3824 are mounted at the front ends of the high frequency probe arms 3821and/or the low frequency probe arms 3822.The probe arm moving mechanism 3823 includes a three-dimensional mechanically moving part 38231 and a three-dimensional piezoelectrically moving part 38232.Each of the high frequency probe arms 3821and/or the low frequency probe arms 3822 can be move independently. The three-dimensional mechanically moving part 38231allows a probe arm to move rapidly within a certain range. A rapid, large-scale positioning can be accomplished by the three-dimensional mechanically moving part 38231, with the aid of the SEM imaging, function inside the chamber. Then, a 10-nm grade precise positioning can be accomplished by the three-dimensional piezoelectrically moving part 38232, with the aid of the SEM imaging function inside the chamber. The four probes 3824, according to the need, may serve either as probes for inputting and outputting high frequency signals simultaneously or as two high frequency probes and two ordinary probes. When there is no need to perform high frequency measurement, the probes 3824 can be replaced with ordinary probes. By means of high frequency probes, high frequency signals can be directly exported to a nanoscale device, and high frequency signals can be directly obtained from the nanoscale device. Ordinary probes can be used for the measurement of low frequency or DC signals. The configuration of theprobe3824 is specifically set according to the characteristics of the test sample 4. For a probe used for electromagnetic characteristic measurement in an ultra-wideband range, the tip of the probe has a basic ground-signal-ground (GSG) structure, and the probe-angle distance can be selected from a range of between 50 nm to 100 microns.

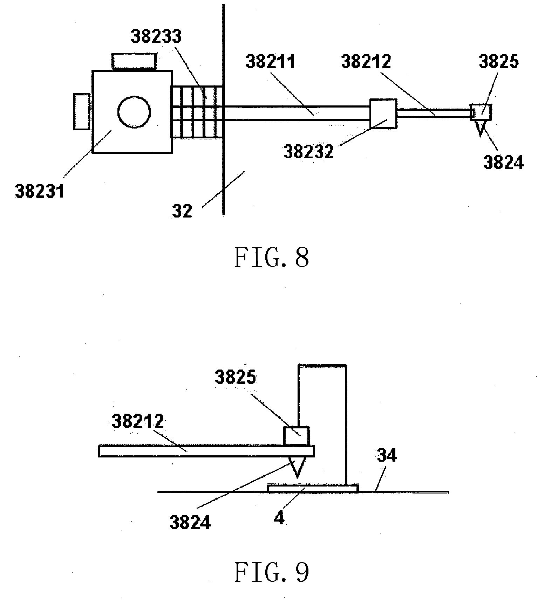

Referring to FIG. 8, which illustrates the structure of a high frequency probe arm in an embodiment of the present invention, in this embodiment, the high frequency probe arms 3821 includes a first probe arm 38211 and a second probe arm 38212, the three-dimensional mechanically moving part 38231 is connected to the first probe arm 38211 via a corrugated tube 38233, and the first probe arm 38211 and the second probe arm 38212 are connected via the three-dimensional piezoelectrically moving part 38232. In case of driving the three-dimensional mechanically moving part 38231, the sample can move quickly within 1 to 12 inches; and, in case of driving the three-dimensional piezoelectrically moving part 38232, a nanoscale precise positioning can be achieved.

The signal transmission device 382 may further comprise probe positioning mechanisms 3825, which are mounted on the high frequency probe arms 3821and/or the low frequency probe arm 3822 and are connected to the control device 2.In this embodiment, the probe positioning mechanism 3825 is preferably a pressure sensor and/or a conductive sensor useful for controlling the contact between the probes 3824 and the surface of the sample 4. The contact force of the probe tip on the surface of the sample is detected by the pressure sensor, which would not cause any damage to the probe tip or the sample. Once a predetermined value is reached, the control device 2 serves to control the probe arm moving apparatus to stop needling, thus ensuring that the sample 4 is not damaged (see FIG. 8); the conductive sensor is used for controlling the needling process of the test conductive sample 4 (see FIG. 9). When conductive samples and devices are to be tested and when the samples will not be damaged because of weak current, conductive sensors can be used. When the sample and the surface are in contact, the current generated by the conductive sensor will enter the sample from the probe tip to form a loop, which can be detected using a voltage, so that the contact force between the probe tip and the sample can be controlled. A rather low voltage is applied between the tip of the probe 3824 and the sample 4 in advance. When they communicate with each other, i.e. a current is observed, it can be considered that there is already a good ohmic contact between the tip of the probe 3824 and the sample 4.

The signal generation device 381 comprises a high frequency network analyzer 3811, a voltage source 3812 and a current source 3813,wherein the high frequency probe arms 3821and/or the low frequency probe arms 3824 are connected to the high frequency network analyzer 3811, the voltage source 3812 and the current source 3813,respectively.

The signal analysis device 383 comprises a spectrum analyzer, which is connected to the high frequency probe arms 3821and/or the low frequency probe arms 3824 and the control device 2, respectively.

Generation, measurement and analysis of the high/wide-band signals all can be accomplished with the high frequency network analyzer 3811 and the spectrum analyzer (the frequency is up to 100 GHz, and can be set according to the users' needs and the signals in different frequency bands). The high frequency signals may come from a commercial high frequency signal source, which is generally generated by a quartz crystal oscillator or a semiconductor capacitance-inductance (RLC) oscillator; a spin oscillator based on nano-ring magnetic tunnel junctions can also be selected (For example, the microwave oscillators disclosed in the Chinese invention patent applications No.200810119751.X and No. 200810222965.X, wherein the high frequency range is 500M to 20GHz. Because these devices are characterized in that they are miniature devices easy to integrate and the frequency can be regulated and controlled by DC signals or magnetic fields, they can be used not only in various high-frequency apparatuses, such as microwave generators and detectors, wireless communication systems, airborne radar signal generators, and CPU systems in computers, but also in the high frequency signal generation source apparatus of the present invention). Generation, measurement and analysis of the low frequency and DC signals all can be accomplished with high precision lock-in amplifiers (e.g. Model SR830), nanovoltmeters (e.g. Keithley 2182A) and current sourcemeters (e.g. Keithley 2600), etc. Coaxial cable wires with a noise suppression effect can be chosen as cables.

A sample stage moving apparatus 341 is further arranged inside the vacuum chamber 32 for the large-scale movement and precise positioning of the sample. The sample stage 34 is mounted on the sample stage moving mechanism 34 which is connected to the control device 2.In addition, the sample stage 34 is provided with a vertical-lift small-sized sample stage 342 (see FIG. 6B). A larger-scale movement of the sample 4 is achieved by the sample stage moving mechanism 341. Also, mechanical movement in a limited range and nanoscale precise movement driven by piezoelectric ceramics can be achieved by the high frequency probe arms 3821.

The present invention has the function of micro/nano-processing and imaging as well as electrical transport and magnetic-electric characteristic test under the regulation and control of electric and magnetic fields, and has the capability to detect high-frequency magnetic-electric signals. Since it has a highly integrated function and is easy to achieve a rapid batch testing of devices, it can be widely used in the fields of measurement and study of semiconductor, microelectronic, magneto-electronic and spintronic materials and the devices thereof, and also can be widely used in the batch testing and quality control of the related electronic products in the information industry.

The present invention does overcome the deficiencies of the prior art. There is only a need for a simple nano-processing, or a nano-processing comprising just a few steps, of the needed nano material or device, and then, under the guidance of the EBL imaging, probes are positioned and brought into direct contact with the nano-material or device to be tested. Further, a stepper motor is used to manipulate the magnetic core electrode of the magnetic field for measurement or the plate electrode of the electric field, and the magnetic or electric field is applied uniformly to a central region of about one square inch (the scope of the uniform magnetic or electric field can be determined according to the need)on the observation platform; then the electron beam for EBL imaging is automatically turned off and switched to the *in situ* magnetic-electric characteristic test control system in a wide frequency band, including the DC and low frequency magnetic/electrical transport test, the generation, transmission and test of high frequency (GHz) signals, and so on. In this measurement, the sample to be tested can be directly selected *in situ,* and the probe arms and the sample stage all can move relatively within a wide range. Therefore, this measurement serves to efficiently test array nanostructures or nanodevices, and thus has advantages such as fast speed, short cycle, high efficiency, great probability of test success, and so on. Such *in-situ* test also applies to the batch testing, quality control and other aspects of industrial high-frequency semiconductor devices or magneto-electronic devices and products.

Of course, the present invention may have a variety of other embodiments. Those skilled in the art can make all kinds of corresponding changes and modifications according to the present invention without departing from the present invention as defined in the appended claims. It is intended that all these changes and modifications be covered by the appended claims of the present invention.

### INDUSTRIAL APPLICABILITY

The nano-patterning and ultra-wideband electromagnetic characteristic measurement system of the present invention is based on an EBL system containing an SEM high resolution imaging function. On the basis of micro/nano-structured imaging and patterning, a uniform magnetic or electric field is effectively led to the central region of the sample stage, the wideband electromagnetic signals are led and applied to a nanostructure or device using probes having a nanoscale positioning function, and the import, export and test analysis of wideband electromagnetic signals are also involved. The system is useful for the patterning and morphology observation of array nano-materials and devices and for the testing and analysis of ultra-wideband magnetic/electrical transport characteristics under *in-situ* conditions.

Compared to the prior art, the present invention is integrated with a variety of functions of testing and studying the high-frequency magnetic, electrical and optical characteristics *in situ,* or a function of studying a comprehensive test, on the basis of the EBL function, thus it can be used to quickly and efficiently test and study nano-materials and devices as well as the array samples thereof. Therefore, the present invention can be widely used in many fields and meet the extensive market demand.

## Claims

1. A nano-patterning and ultra-wideband electromagnetic characteristic measurement system, comprising a power source (1), a control device (2) and a measurement device (3), the control device (2) being connected to the measurement device, and the control device (2) and the measurement device being respectively connected to the power source (1), **characterized in that** the measurement device (3) includes an imaging device (31) with an SEM imaging or EBL patterning function, a vacuum chamber (32), a vacuum system (33), a sample stage (34) and a magnetic-field response characteristic test device (35), wherein the vacuum system (33) is connected to the vacuum chamber (32), wherein the imaging device (31), the sample stage (34) and the magnetic-field response characteristic test device (35) all are arranged inside the vacuum chamber (32), and wherein the imaging device (31) and the magnetic-field response characteristic test device (35) are arranged relative to the sample stage (34).

2. The nano-patterning and ultra-wideband electromagnetic characteristic measurement system according to claim 1, **characterized in that** the magnetic-field response characteristic test device (35) includes a bracket (351), and a magnetic-field generation device (352), a magnetic-field moving mechanism and a magnetic-field shielding apparatus (354) that are mounted on the bracket (351), wherein the magnetic-field generation device (352) includes a coil (3521) and magnetically permeable magnetic poles (3522), the magnetically permeable magnetic poles (3522) are connected to the magnetic-field moving mechanism, and the magnetic-field shielding mechanism is mounted on the bracket (351) and arranged relative to the sample stage (34).

3. The nano-patterning and ultra-wideband electromagnetic characteristic measurement system according to claim 1, **characterized by** further comprising an electric-field response characteristic test device (36), which is arranged inside the vacuum chamber (32) and disposed above the sample stage (34).

4. The nano-patterning and ultra-wideband electromagnetic characteristic measurement system according to claim 2, **characterized by** further comprising an electric-field response characteristic test device (36), which is arranged inside the vacuum chamber (32) and disposed above the sample stage (34).

5. The nano-patterning and ultra-wideband electromagnetic characteristic measurement system according to claim 4, **characterized in that** the electric-field response characteristic test device (36) includes a vertical electric-field applying plate and/or horizontal electric-field applying plates and a plate moving mechanism, the vertical electric-field applying plate and/or the horizontal electric-field applying plates being respectively connected to the plate moving mechanism.

6. The nano-patterning and ultra-wideband electromagnetic characteristic measurement system according to claim 1, **characterized by** further comprising a photo response characteristic test device (37) which includes a light source (371) and a photo response characteristic test component (372), the photo response characteristic test component (372) being arranged inside the vacuum chamber (32).

7. The nano-patterning and ultra-wideband electromagnetic characteristic measurement system according to claim 2, **characterized by** further comprising a photo response characteristic test device (37) which includes a light source (371) and a photo response characteristic test component (372), the photo response characteristic test component (372) being arranged inside the vacuum chamber (32).

8. The nano-patterning and ultra-wideband electromagnetic characteristic measurement system according to claim 3, **characterized by** further comprising a photo response characteristic test device (37) which includes a light source (371) and a photo response characteristic test component (372), the photo response characteristic test component (372) being arranged inside the vacuum chamber (32).

9. The nano-patterning and ultra-wideband electromagnetic characteristic measurement system according to claim 4, **characterized by** further comprising a photo response characteristic test device (37) which includes a light source (371) and a photo response characteristic test component (372), the photo response characteristic test component (372) being arranged inside the vacuum chamber (32).

10. The nano-patterning and ultra-wideband electromagnetic characteristic measurement system according to claim 5, **characterized by** further comprising a photo response characteristic test device (37) which includes a light source (371) and a photo response characteristic test component (372), the photo response characteristic test component (372) being arranged inside the vacuum chamber (32).

11. The nano-patterning and ultra-wideband electromagnetic characteristic measurement system according to claim 1, **characterized by** further comprising a wideband signal test analysis device (38) which includes a signal generation device (381), a signal transmission device (382) and a signal analysis device (383), the signal generation device (381) and the signal analysis device (383) being respectively connected to the signal transmission device (382), and the signal transmission device (382) being connected to the vacuum chamber (32) and arranged relative to the sample stage (34).

12. The nano-patterning and ultra-wideband electromagnetic characteristic measurement system according to claim 2, **characterized by** further comprising a wideband signal test analysis device (38) which includes a signal generation device (381), a signal transmission device (382) and a signal analysis device (383), the signal generation device (381) and the signal analysis device (383) being respectively connected to the signal transmission device (382), and the signal transmission device (382) being connected to the vacuum chamber (32) and arranged relative to the sample stage (34).

13. The nano-patterning and ultra-wideband electromagnetic characteristic measurement system according to claim 3, **characterized by** further comprising a wideband signal test analysis device (38) which includes a signal generation device (381), a signal transmission device (382) and a signal analysis device (383), the signal generation device (381) and the signal analysis device (383) being respectively connected to the signal transmission device (382), and the signal transmission device (382) being connected to the vacuum chamber (32) and arranged relative to the sample stage (34).

14. The nano-patterning and ultra-wideband electromagnetic characteristic measurement system according to claim 6, **characterized by** further comprising a wideband signal test analysis device (38) which includes a signal generation device (381), a signal transmission device (382) and a signal analysis device (383), the signal generation device (381) and the signal analysis device (383) being respectively connected to the signal transmission device (382), and the signal transmission device (382) being connected to the vacuum chamber (32) and arranged relative to the sample stage (34).

15. The nano-patterning and ultra-wideband electromagnetic characteristic measurement system according to claim 11, **characterized in that** the signal transmission device (382) comprises high frequency probe arms (3821) and/or low frequency probe arms (3822), probe arm moving mechanisms (3823) and probes (3824), the high frequency probe arms (3821) and/or the low frequency probe arms (3822) being connected to the probe arm moving mechanisms (3823), and the probes (3824) being mounted at the front ends of the high frequency probe arms (3821) and/or the low frequency probe arms (3822).

16. The nano-patterning and ultra-wideband electromagnetic characteristic measurement system according to claim 14, **characterized in that** the signal transmission device (382) comprises high frequency probe arms (3821) and/or low frequency probe arms (3822), probe arm moving mechanisms (3823) and probes (3824), the high frequency probe arms (3821) and/or the low frequency probe arms (3822) being connected to the probe arm moving mechanisms (3823), and the probes (3824) being mounted at the front ends of the high frequency probe arms (3821) and/or the low frequency probe arms (3822).

17. The nano-patterning and ultra-wideband electromagnetic characteristic measurement system according to claim 15, **characterized in that** the signal transmission device (382) further comprises probe positioning apparatus (3825), which are mounted at the front ends of the high frequency probe arms (3821) and/or the low frequency probe arms (3822) and are connected to the control device (2).

18. The nano-patterning and ultra-wideband electromagnetic characteristic measurement system according to claim 16, **characterized in that** the signal transmission device (382) further comprises probe positioning apparatus (3825), which are mounted at the front ends of the high frequency probe arms (3821) and/or the low frequency probe arms (3822) and are connected to the control device (2).

19. The nano-patterning and ultra-wideband electromagnetic characteristic measurement system according to claim 15, **characterized in that** the signal generation device (381) comprises a high frequency network analyzer (3811), a voltage source (3812) and a current source (3813), the high frequency probe arms (3821) and/or the low frequency probe arms (3822) being connected to the high frequency network analyzer (3811), the voltage source (3812) and the current source (3813), respectively.

20. The nano-patterning and ultra-wideband electromagnetic characteristic measurement system according to claim 1, **characterized in that** a sample stage (34) moving apparatus is further arranged inside the vacuum chamber (32), the sample stage being mounted on the sample stage moving mechanism (341) which is connected to the control device (2).

## Patentansprüche

1. System zur Messung von Nanostrukturierungen und von ultrabreitbandigen elektromagnetischen Charakteristiken, welches eine Energiequelle (1), eine Steuervorrichtung (2) und eine Messvorrichtung (3) umfasst, wobei die Steuervorrichtung (2) mit der Messvorrichtung verbunden ist, und wobei die Steuervorrichtung (2) und die Messvorrichtung jeweils mit der Energiequelle (1) verbunden sind, **dadurch gekennzeichnet, dass** die Messvorrichtung (3) eine Bildaufnahmeeinrichtung (31) mit einer REM-Bild- oder ESL-Strukturierungsfunktion, eine Vakuumkammer (32), ein Vakuumsystem (33), einen Probentisch (34) und eine Magnetfeld-Ansprechcharakteristiktesteinrichtung (35) umfasst, wobei das Vakuumsystem (33) mit der Vakuumkammer (32) verbunden ist, wobei die Bildaufnahmeeinrichtung (31), der Probentisch (34) und die Magnetfeld-Ansprechcharakteristiktesteinrichtung (35) alle innerhalb der Vakuumkammer (32) angeordnet sind, und wobei die Bildaufnahmeeinrichtung (31) und die Magnetfeld-Ansprechcharakteristiktesteinrichtung (35) relativ zu dem Probentisch (34) angeordnet sind.

2. System zur Messung von Nanostrukturierungen und von ultrabreitbandigen elektromagnetischen Charakteristiken nach Anspruch 1, **dadurch gekennzeichnet, dass** die Magnetfeld-Ansprechcharakteristiktesteinrichtung (35) eine Halterung (351), und eine Magnetfelderzeugungseinrichtung (352), einen Magnetfeldbewegungsmechanismus und ein Magnetfeldabschirmgerät (354), welche an der Halterung (351) befestigt sind, umfasst, wobei die Magnetfelderzeugungseinrichtung (352) eine Spule (3521) und magnetisch permeable magnetische Pole (3522) umfasst, die magnetisch permeablen magnetischen Pole (3522) mit dem Magnetfeldbewegungsmechanismus verbunden sind, und der Magnetfeldabschirmmechanismus an der Halterung (351) befestigt und relativ zu dem Probentisch (34) angeordnet ist.

3. System zur Messung von Nanostrukturierungen und von ultrabreitbandigen elektromagnetischen Charakteristiken nach Anspruch 1, **gekennzeichnet durch** ferner umfassend eine Elektrisches-Feld-Ansprechcharakteristiktesteinrichtung (36), welche innerhalb der Vakuumkammer (32) angeordnet und oberhalb des Probentisches (34) angeordnet ist.

4. System zur Messung von Nanostrukturierungen und von ultrabreitbandigen elektromagnetischen Charakteristiken nach Anspruch 2, **gekennzeichnet durch** ferner umfassend eine Elektrisches-Feld-Ansprechcharakteristiktesteinrichtung (36), welche innerhalb der Vakuumkammer (32) angeordnet und oberhalb des Probentisches (34) angeordnet ist.

5. System zur Messung von Nanostrukturierungen und von ultrabreitbandigen elektromagnetischen Charakteristiken nach Anspruch 4, **dadurch gekennzeichnet, dass** die Elektrisches-Feld-Ansprechcharakteristiktesteinrichtung (36) eine Vertikales-elektrisches-Feld-Anlegeplatte und/oder Horizontales-elektrisches-Feld-Anlegeplatten und einen Plattenbewegungsmechanismus umfasst, wobei die Vertikales-elektrisches-Feld-Anlegeplatte und/oder die Horizontales-elektrisches-Feld-Anlegeplatten jeweils mit dem Plattenbewegungsmechanismus verbunden sind.

6. System zur Messung von Nanostrukturierungen und von ultrabreitbandigen elektromagnetischen Charakteristiken nach Anspruch 1, **gekennzeichnet durch** ferner umfassend eine Photo-Ansprechcharakteristiktesteinrichtung (37), welche eine Lichtquelle (371) und eine Photo-Ansprechcharakteristiktestkomponente (372) umfasst, wobei die Photo-Ansprechcharakteristiktestkomponente (372) innerhalb der Vakuumkammer (32) angeordnet ist.

7. System zur Messung von Nanostrukturierungen und von ultrabreitbandigen elektromagnetischen Charakteristiken nach Anspruch 2, **gekennzeichnet durch** ferner umfassend eine Photo-Ansprechcharakteristiktesteinrichtung (37), welche eine Lichtquelle (371) und eine Photo-Ansprechcharakteristiktestkomponente (372) umfasst, wobei die Photo-Ansprechcharakteristiktestkomponente (372) innerhalb der Vakuumkammer (32) angeordnet ist.

8. System zur Messung von Nanostrukturierungen und von ultrabreitbandigen elektromagnetischen Charakteristiken nach Anspruch 3, **gekennzeichnet durch** ferner umfassend eine Photo-Ansprechcharakteristiktesteinrichtung (37), welche eine Lichtquelle (371) und eine Photo-Ansprechcharakteristiktestkomponente (372) umfasst, wobei die Photo-Ansprechcharakteristiktestkomponente (372) innerhalb der Vakuumkammer (32) angeordnet ist.

9. System zur Messung von Nanostrukturierungen und von ultrabreitbandigen elektromagnetischen Charakteristiken nach Anspruch 4, **gekennzeichnet durch** ferner umfassend eine Photo-Ansprechcharakteristiktesteinrichtung (37), welche eine Lichtquelle (371) und eine Photo-Ansprechcharakteristiktestkomponente (372) umfasst, wobei die Photo-Ansprechcharakteristiktestkomponente (372) innerhalb der Vakuumkammer (32) angeordnet ist.

10. System zur Messung von Nanostrukturierungen und von ultrabreitbandigen elektromagnetischen Charakteristiken nach Anspruch 5, **gekennzeichnet durch** ferner umfassend eine Photo-Ansprechcharakteristiktesteinrichtung (37), welche eine Lichtquelle (371) und eine Photo-Ansprechcharakteristiktestkomponente (372) umfasst, wobei die Photo-Ansprechcharakteristiktestkomponente (372) innerhalb der Vakuumkammer (32) angeordnet ist.

11. System zur Messung von Nanostrukturierungen und von ultrabreitbandigen elektromagnetischen Charakteristiken nach Anspruch 1, **gekennzeichnet durch** ferner umfassend eine Breitbandsignaltestanalyseeinrichtung (38), welche eine Signalerzeugungseinrichtung (381), eine Signalübertragungseinrichtung (382) und eine Signalanalyseeinrichtung (383) umfasst, wobei die Signalerzeugungseinrichtung (381) und die Signalanalyseeinrichtung (383) jeweils mit der Signalübertragungseinrichtung (382) verbunden sind, und wobei die Signalübertragungseinrichtung (382) mit der Vakuumkammer (32) verbunden und relativ zu dem Probentisch (34) angeordnet ist.

12. System zur Messung von Nanostrukturierungen und von ultrabreitbandigen elektromagnetischen Charakteristiken nach Anspruch 2, **gekennzeichnet durch** ferner umfassend eine Breitbandsignaltestanalyseeinrichtung (38), welche eine Signalerzeugungseinrichtung (381), eine Signalübertragungseinrichtung (382) und eine Signalanalyseeinrichtung (383) umfasst, wobei die Signalerzeugungseinrichtung (381) und die Signalanalyseeinrichtung (383) jeweils mit der Signalübertragungseinrichtung (382) verbunden sind, und wobei die Signalübertragungseinrichtung (382) mit der Vakuumkammer (32) verbunden und relativ zu dem Probentisch (34) angeordnet ist.

13. System zur Messung von Nanostrukturierungen und von ultrabreitbandigen elektromagnetischen Charakteristiken nach Anspruch 3, **gekennzeichnet durch** ferner umfassend eine Breitbandsignaltestanalyseeinrichtung (38), welche eine Signalerzeugungseinrichtung (381), eine Signalübertragungseinrichtung (382) und eine Signalanalyseeinrichtung (383) umfasst, wobei die Signalerzeugungseinrichtung (381) und die Signalanalyseeinrichtung (383) jeweils mit der Signalübertragungseinrichtung (382) verbunden sind, und wobei die Signalübertragungseinrichtung (382) mit der Vakuumkammer (32) verbunden und relativ zu dem Probentisch (34) angeordnet ist.

14. System zur Messung von Nanostrukturierungen und von ultrabreitbandigen elektromagnetischen Charakteristiken nach Anspruch 6, **gekennzeichnet durch** ferner umfassend eine Breitbandsignaltestanalyseeinrichtung (38), welche eine Signalerzeugungseinrichtung (381), eine Signalübertragungseinrichtung (382) und eine Signalanalyseeinrichtung (383) umfasst, wobei die Signalerzeugungseinrichtung (381) und die Signalanalyseeinrichtung (383) jeweils mit der Signalübertragungseinrichtung (382) verbunden sind, und wobei die Signalübertragungseinrichtung (382) mit der Vakuumkammer (32) verbunden und relativ zu dem Probentisch (34) angeordnet ist.

15. System zur Messung von Nanostrukturierungen und von ultrabreitbandigen elektromagnetischen Charakteristiken nach Anspruch 11, **dadurch gekennzeichnet, dass** die Signalübertragungseinrichtung (382) Hochfrequenztastarme (3821) und/oder Niederfrequenztastarme (3822), Tastarmbewegungsmechanismen (3823) und Taster (3824) umfasst, wobei die Hochfrequenztastarme (3821) und/oder die Niederfrequenztastarme (3822) mit den Tastarmbewegungsmechanismen (3823) verbunden sind, und wobei die Taster (3824) an den Stirnseiten der Hochfrequenztastarme (3821) und/oder der Niederfrequenztastarme (3822) befestigt sind.

16. System zur Messung von Nanostrukturierungen und von ultrabreitbandigen elektromagnetischen Charakteristiken nach Anspruch 14, **dadurch gekennzeichnet, dass** die Signalübertragungseinrichtung (382) Hochfrequenztastarme (3821) und/oder Niederfrequenztastarme (3822), Tastarmbewegungsmechanismen (3823) und Taster (3824) umfasst, wobei die Hochfrequenztastarme (3821) und/oder die Niederfrequenztastarme (3822) mit den Tastarmbewegungsmechanismen (3823) verbunden sind, und wobei die Taster (3824) an den Stirnseiten der Hochfrequenztastarme (3821) und/oder der Niederfrequenztastarme (3822) befestigt sind.

17. System zur Messung von Nanostrukturierungen und von ultrabreitbandigen elektromagnetischen Charakteristiken nach Anspruch 15, **dadurch gekennzeichnet, dass** die Signalübertragungseinrichtung (382) ferner Tasterpositionierungsgeräte (3825) umfasst, welche an den Stirnseiten der Hochfrequenztastarme (3821) und/oder der Niederfrequenztastarme (3822) befestigt sind und mit der Steuervorrichtung (2) verbunden sind.

18. System zur Messung von Nanostrukturierungen und von ultrabreitbandigen elektromagnetischen Charakteristiken nach Anspruch 16, **dadurch gekennzeichnet, dass** die Signalübertragungseinrichtung (382) ferner Tasterpositionierungsgeräte (3825) umfasst, welche an den Stirnseiten der Hochfrequenztastarme (3821) und/oder der Niederfrequenztastarme (3822) befestigt sind und mit der Steuervorrichtung (2) verbunden sind.

19. System zur Messung von Nanostrukturierungen und von ultrabreitbandigen elektromagnetischen Charakteristiken nach Anspruch 15, **dadurch gekennzeichnet, dass** die Signalerzeugungseinrichtung (381) einen Hochfrequenznetzwerkanalysator (3811), eine Spannungsquelle (3812) und eine Stromquelle (3813) umfasst, wobei die Hochfrequenztastarme (3821) und/oder die Niederfrequenztastarme (3822) jeweils mit dem Hochfrequenznetzwerkanalysator (3811), der Spannungsquelle (3812) und der Stromquelle (3813) verbunden sind.

20. System zur Messung von Nanostrukturierungen und von ultrabreitbandigen elektromagnetischen Charakteristiken nach Anspruch 1, **dadurch gekennzeichnet, dass** ferner ein Probentisch- (34) Bewegungsgerät innerhalb der Vakuumkammer (32) angeordnet ist, wobei der Probentisch an dem Probentisch-Bewegungsmechanismus (341) befestigt ist, welcher mit der Steuervorrichtung (2) verbunden ist.

## Revendications

1. Système de mesure de caractéristique électromagnétique à bande ultralarge et à nano-structuration comprenant une source d'alimentation (1), un dispositif de commande (2) et un dispositif de mesure (3), le dispositif de commande (2) étant relié au dispositif de mesure, et le dispositif de commande (2) et le dispositif de mesure étant chacun reliés à la source d'alimentation (1), **caractérisé en ce que** le dispositif de mesure (3) comprend un dispositif d'imagerie (31) avec une imagerie MEB ou une fonction de structuration LFE, une chambre de vide (32), un système de vide (33), un étage d'échantillon (34) et un dispositif de test caractéristique de réponse à un champ magnétique (35), le système de vide (33) étant relié à la chambre de vide (32), le dispositif d'imagerie (31), l'étage d'échantillon (34) et le dispositif de test caractéristique de réponse à un champ magnétique (35) sont tous disposés à l'intérieur de la chambre de vide (32), et le dispositif d'imagerie (31) et le dispositif de test caractéristique de réponse à un champ magnétique (35) sont disposés par rapport à l'étage d'échantillon (34).

2. Système de mesure de caractéristique électromagnétique à bande ultralarge et à nano-structuration selon la revendication 1, **caractérisé en ce que** le dispositif de test caractéristique de réponse à un champ magnétique (35) comprend un support (351), et un dispositif de génération d'un champ magnétique (352), un mécanisme de déplacement d'un champ magnétique et un dispositif de blindage d'un champ magnétique (354) qui sont montés sur le support (351), le dispositif de génération d'un champ magnétique (352) comprenant une bobine (3521) et des pôles magnétiques magnétiquement perméables (3522), les pôles magnétiques magnétiquement perméables (3522) étant reliés au mécanisme de déplacement d'un champ magnétique, et le dispositif de blindage d'un champ magnétique étant monté sur le support (351) et disposé par rapport à l'étage d'échantillon (34).

3. Système de mesure de caractéristique électromagnétique à bande ultralarge et à nano-structuration selon la revendication 1, **caractérisé en ce qu'**il comprend en outre un dispositif de test caractéristique de réponse à un champ électrique (36), qui est disposé à l'intérieur de la chambre de vide (32) et disposé au-dessus de l'étage d'échantillon (34).

4. Système de mesure de caractéristique électromagnétique à bande ultralarge et à nano-structuration selon la revendication 2, **caractérisé en ce qu'**il comprend en outre un dispositif de test caractéristique de réponse à un champ électrique (36) qui est disposé à l'intérieur de la chambre de vide (32) et disposé au-dessus de l'étage d'échantillon (34).

5. Système de mesure de caractéristique électromagnétique à bande ultralarge et à nano-structuration selon la revendication 4, **caractérisé en ce que** le dispositif de test caractéristique de réponse à un champ électrique (36) comprend une plaque d'application d'un champ électrique vertical et/ou des plaques d'application d'un champ électrique horizontal et un mécanisme de déplacement de plaques, la plaque d'application d'un champ électrique vertical et/ou les plaques d'application d'un champ électrique horizontal étant reliées chacune au mécanisme de déplacement de plaques.

6. Système de mesure de caractéristique électromagnétique à bande ultralarge et à nano-structuration selon la revendication 1, **caractérisé en ce qu'**il comprend en outre un dispositif de test caractéristique d'une photo-réponse (37) qui comprend une source lumineuse (371) et un composant de test caractéristique d'une photo-réponse (372), le composant de test caractéristique d'une photo-réponse (372) étant disposé à l'intérieur de la chambre de vide (32).

7. Système de mesure de caractéristique électromagnétique à bande ultralarge et à nano-structuration selon la revendication 2, **caractérisé en ce qu'**il comprend en outre un dispositif de test caractéristique d'une photo-réponse (37) qui comprend une source lumineuse (371) et un composant de test caractéristique d'une photo-réponse (372), le composant de test caractéristique d'une photo-réponse (372) étant disposé à l'intérieur de la chambre de vide (32).

8. Système de mesure de caractéristique électromagnétique à bande ultralarge et à nano-structuration selon la revendication 3, **caractérisé en ce qu'**il comprend en outre un dispositif de test caractéristique d'une photo-réponse (37) qui comprend une source lumineuse (371) et un composant de test caractéristique d'une photo-réponse (372), le composant de test caractéristique d'une photo-réponse (372) étant disposé à l'intérieur de la chambre de vide (32).

9. Système de mesure de caractéristique électromagnétique à bande ultralarge et à nano-structuration selon la revendication 4, **caractérisé en ce qu'**il comprend en outre un dispositif de test caractéristique d'une photo-réponse (37) qui comprend une source lumineuse (371) et un composant de test caractéristique d'une photo-réponse (372), le composant de test caractéristique d' photo-réponse (372) étant disposé à l'intérieur de la chambre à vide (32).

10. Système de mesure de caractéristique électromagnétique à bande ultralarge et à nano-structuration selon la revendication 5, **caractérisé en ce qu'**il comprend en outre un dispositif de test caractéristique d'une photo-réponse (37) qui comprend une source lumineuse (371) et un composant de test caractéristique d'une photo-réponse (372), le composant de test caractéristique d'une photo-réponse (372) étant disposé à l'intérieur de la chambre de vide (32).

11. Système de mesure de caractéristique électromagnétique à bande ultralarge et à nano-structuration selon la revendication 1, **caractérisé en ce qu'**il comprend en outre un dispositif d'analyse de test d'un signal à large bande (38) qui comprend un dispositif de génération d'un signal (381), un dispositif de transmission d'un signal (382), et un dispositif d'analyse d'un signal (383), le dispositif de génération d'un signal (381) et le dispositif d'analyse d'un signal (383) étant chacun reliés au dispositif de transmission d'un signal (382), et le dispositif de transmission d'un signal (382) étant relié à la chambre de vide (32) et disposé par rapport à l'étage d'échantillon (34).

12. Système de mesure de caractéristique électromagnétique à bande ultralarge et à nano-structuration selon la revendication 2, **caractérisé en ce qu'**il comprend en outre un dispositif d'analyse de test d'un signal à large bande (38) qui comprend un dispositif de génération d'un signal (381), un dispositif de transmission d'un signal (382), et un dispositif d'analyse d'un signal (383), le dispositif de génération d'un signal (381) et le dispositif d'analyse d'un signal (383) étant chacun relié au dispositif de transmission d'un signal (382), et le dispositif de transmission d'un signal (382) étant relié à la chambre de vide (32) et disposé par rapport à l'étage d'échantillon (34).

13. Système de mesure de caractéristique électromagnétique à bande ultralarge et à nano-structuration selon la revendication 3, **caractérisé en ce qu'**il comprend en outre un dispositif d'analyse de test d'un signal à large bande (38) qui comprend un dispositif de génération d'un signal (381), un dispositif de transmission d'un signal (382), et un dispositif d'analyse d'un signal (383), le dispositif de génération d'un signal (381) et le dispositif d'analyse d'un signal (383) étant chacun reliés au dispositif de transmission d'un signal (382), et le dispositif de transmission d'un signal (382) étant relié à la chambre de vide (32) et disposé par rapport à l'étage d'échantillon (34).

14. Système de mesure de caractéristique électromagnétique à bande ultralarge et à nano-structuration selon la revendication 6, **caractérisé en ce qu'**il comprend en outre un dispositif d'analyse de test d'un signal à large bande (38) qui comprend un dispositif de génération d'un signal (381), un dispositif de transmission d'un signal (382), et un dispositif d'analyse d'un signal (383), le dispositif de génération d'un signal (381) et le dispositif d'analyse d'un signal (383) étant chacun relié au dispositif de transmission d'un signal (382), et le dispositif de transmission d'un signal (382) étant relié à la chambre de vide (32) et disposé par rapport à l'étage d'échantillon (34).

15. Système de mesure de caractéristique électromagnétique à bande ultralarge et à nano-structuration selon la revendication 11, **caractérisé en ce que** le dispositif de transmission d'un signal (382) comporte des bras de sonde à haute fréquence (3821) et/ou des bras de sonde à basse fréquence (3822), des mécanismes de déplacement de bras de sonde (3823) et des sondes (3824), les bras de sonde à haute fréquence (3821) et/ou les bras de sonde à basse fréquence (3822) étant reliés aux mécanismes de déplacement de bras de sonde (3823) et les sondes (3824) étant montées aux extrémités avant des bras de sonde à haute fréquence (3821) et/ou des bras de sonde à basse fréquence (3822).

16. Système de mesure de caractéristique électromagnétique à bande ultralarge et à nano-structuration selon la revendication 14, **caractérisé en ce que** le dispositif de transmission d'un signal (382) comporte des bras de sonde à haute fréquence (3821) et/ou des bras de sonde à basse fréquence (3822), des mécanismes de déplacement de bras de sonde (3823) et des sondes (3824), les bras de sonde à haute fréquence (3821) et/ou les bras de sonde à basse fréquence (3822) étant reliés aux mécanismes de déplacement de bras de sonde (3823) et les sondes (3824) étant montées aux extrémités avant des bras de sonde à haute fréquence (3821) et/ou des bras de sonde à basse fréquence (3822).

17. Système de mesure de caractéristique électromagnétique à bande ultralarge et à nano-structuration selon la revendication 15, **caractérisé en ce que** le dispositif de transmission d'un signal (382) comprend en outre des dispositifs de positionnement de sonde (3825) qui sont montés aux extrémités avant des bras de sonde à haute fréquence (3821) et/ou des bras de sonde à basse fréquence (3822) et sont reliés au dispositif de commande (2).

18. Système de mesure de caractéristique électromagnétique à bande ultralarge et à nano-structuration selon la revendication 16, **caractérisé en ce que** le dispositif de transmission d'un signal (382) comprend en outre des dispositifs de positionnement de sonde (3825) qui sont montés aux extrémités avant des bras de sonde à haute fréquence (3821) et/ou des bras de sonde à basse fréquence (3822) et sont reliés au dispositif de commande (2).

19. Système de mesure de caractéristique électromagnétique à bande ultralarge et à nano-structuration selon la revendication 15, **caractérisé en ce que** le dispositif de génération d'un signal (381) comprend un analyseur de réseau à haute fréquence (3811), une source de tension (3812) et une source de courant (3813), les bras de sonde à haute fréquence (3821) et/ou les bras de sonde à basse fréquence (3822) étant reliés à l'analyseur de réseau à haute fréquence (3811), à la source de tension (3812) et à la source de courant (3813), respectivement.

20. Système de mesure de caractéristique électromagnétique à bande ultralarge et à nano-structuration selon la revendication 1, **caractérisé en ce qu'**un dispositif de déplacement d'étage d'échantillon (34) est en outre disposé à l'intérieur de la chambre de vide (32), l'étage d'échantillon étant monté sur le mécanisme de déplacement d'étage d'échantillon (341) qui est relié au dispositif de commande (2).
